# EUROPEAN PATENT APPLICATION

(11) **EP 3 435 132 A2**
(43) Date of publication of application: **30.01.2019**
(21) Application number: 18178483.6
(22) Date of filing: 06.05.2015
(51) Int. Cl.: G02B 17/00, G02B 26/08, G02B 27/18, G03B 21/28, G02B 19/00, G01N 21/88, G03B 21/20, H04N 9/31, G02B 27/09, G03B 21/00

(54) **LIGHT EMITTING DIODE DIGITAL MICROMIRROR DEVICE ILLUMINATOR**

(30) Priority: 10.05.2014 US 201461991488 P
(62) Divisional of application: 15792480.4
(71) Applicant: Innovations in Optics, Inc., Woburn, MA 01801 (US)
(72) Inventor: BRUKILACCHIO, Thomas John, Reading, MA 01867 (US)
(74) Representative: Heinze, Ekkehard

(57) **Abstract**

A light emitting diode (LED) projector for a digital micromirror device (DMD) comprising at least one LED die; a DMD; a non-imaging collection optic having an input aperture in optical communication with the at least one LED die and having an output aperture; an illumination lens system in optical communication with the output aperture of the non-imaging collection optic and the DMD, and configured to generate an image of the output aperture in an image plane that includes the DMD, the illumination lens system being telecentric in an object space which includes the output aperture of the non-imaging collection optic, the illumination lens system having a first aperture stop having an elliptical or rectangular shape to limit the angular acceptance of light in a mirror plane of the DMD relative to an angular acceptance of light in an orthogonal plane to thereby increase the average numerical aperture of the illumination lens system; and a projection lens system in optical communication with the DMD and having a second aperture stop having an elliptical or rectangular shape to pass all the power exiting the DMD.

## Description

### RELATED APPLICATION

This application claims the benefit of the earlier filing dates of U.S. Provisional Patent Application Serial No. 61/991,488, filed May 10, 2014 and titled "High Radiance Ultraviolet Light Emitting Diode Digital Micromirror Device Illuminator," the entirety of which is incorporated herein by reference.

### FIELD OF THE INVENTION

The invention relates to high radiance Ultraviolet (UV) sources of illumination coupled to projection systems for selectively exposing photocurable materials in applications such as maskless lithography and printing.

### BACKGROUND

High brightness light emitting diode (LED) light sources have only recently become available at performance levels suitable for challenging high intensity applications in UV curing. There has been a significant increase in the use and value of UV cured materials in the manufacturing process due to significantly higher production throughput afforded by the extremely fast curing of materials in comparison to curing by other conventional means including heat, non-photoinitiated chemical interactions of adhesives, evaporation of volatiles, and the like. This improvement in process time has significant value to the manufacturing community. Imaged UV curing in the case of maskless lithography saves considerable cost in eliminating the need to produce the mask, in addition to the time savings.

Conventional UV curing devices typically utilize short arc mercury lamps, xenon lamps, lasers and more recently, systems incorporating pre-packaged high brightness LEDs. Conventional arc lamps suffer from significant arc flicker resulting in the need to homogenize the light which in typical non-Etendue preserving designs reduces radiance (optical power per unit area per unit solid angle [W/cm²/sr]). Arc lamps also suffer from poor lifetime and rapidly decreasing output as a function of time with lifetimes in the hundreds to low thousands of hours at best. This results in added system cost and maintenance expense relative to LED sources which are more stable in output in both the short and long term, and characterized by lifetimes of tens of thousands of hours given proper attention to thermal design. In the last several years laser diodes have been used to replace arc lamps, however, laser diodes are extremely expensive compared to both arc lamps and LEDs, and suffer from image artifacts due to the high temporal and spatial coherence relative to LEDs. Conventional implementations using LEDs, however, suffer from relatively low radiance and lifetime due to limitations of their optical, mechanical and thermal designs.

Prepackaged LEDs are defined as devices comprising an LED die or die array sitting on top of one or more thermally and electrically conductive materials. The thermal impedances of these multiple interfaces leads to a cumulative total thermal impedance that results in high LED junction temperature, thereby degrading LED output and life. Examples of prepackaged UV LED devices include those offered by the SemiLeds® and Nichia® product lines.

### SUMMARY

A UV LED digital micromirror device (DMD) illuminator according to embodiments of the invention uses "Chip-on-Board" (COB) metal core printed circuit board (PCB) technology, a heat spreader and a water heat exchanger in conjunction with high efficiency compact non-imaging and imaging optics to provide a more compact, higher performance, longer life, and lower cost system relative to systems incorporating pre-packaged LED devices that are commercially available. The diamond heat spreader is characterized by four to five times the thermal conductivity of bulk copper and thus acts to significantly reduce heat flux going into the metal core board and water heat exchanger which in turn reduces the LED junction temperature. The thermal impedance between the LED junction and the heat sink is significantly reduced for COB technology combined with diamond heat spreaders by placing the LED die array directly on a diamond heat spreader which is subsequently mounted to a metal core board (or other high thermal conductivity material substrate or heat spreader), thereby increasing temperature dependent life and thermally dependent output power. High efficiency water heat exchangers may be included with various embodiments. Alternatively, high thermal efficiency heat pipes may be used with systems that require no water or a hybrid two stage water heat exchanger combined with heat pipes.

The combination of COB technology, high thermal conductivity heat spreaders, high thermal conductivity substantially void free solder, high performance water heat exchanger and high efficiency non-imaging and aberration corrected telecentric imaging optics results in one preferred embodiment of the invention which provides the required high uniformity as well as telecentric illumination required for use in conjunction with DMDs utilizing total internal reflection (TIR) prisms. Alternatively, the system of lenses can be configured to accommodate a non-telecentric stop for systems that do not use TIR prisms produced, for example, by Texas Instruments®. The DMD is combined with a high performance projection lens system to image the UV light from the DMD onto the illumination plane of interest for the primary purpose of selectively curing photocurable materials.

Illuminators, according to embodiments of the invention, provide a highly reliable and high power density source of uniform illumination for use in a variety of applications including maskless lithography and selective curing of printed inks.

Embodiments of the invention described herein include a high radiance UV LED illuminator that projects onto a DMD as a source of high radiance UV energy to be subsequently imaged by a well corrected projection lens with minimal distortion onto an illumination plane with a high degree of spatial uniformity and high intensity. Applications include acting as the illumination portion of a system designed for maskless lithography and other related UV cured materials applications or as a part of a system providing structured fluorescence excitation.

An LED die or die array, which is comprised of one or more spectral bands in the UV, is arranged on a high thermal conductivity diamond heat spreader attached by high thermal conductivity substantially void free solder, which is mounted to a high thermal conductivity metal core copper LED board by similar substantially void free solder, which in turn is cooled by a water based heat exchanger. The UV optical power emitting by the LED array is emitted into a substantially Lambertian distribution and is substantially collected by a non-imaging optic with rectangular input and output apertures with an aspect ratio that substantially matches that of the given DMD module. The length and output aperture are selected to optimally homogenize the Near Field (NF) spatial uniformity at the output aperture of the non-imaging collection optic, which in one embodiment is a tapered glass light pipe ("taper"). The aspect ratio of the rectangular output of the taper is substantially similar to that of the DMD such that the output of the taper is subsequently imaged by a low distortion, near diffraction limited lens system onto the DMD aperture. The lens system of the projection lens is configured such that the DMD is the limiting factor in image quality, not the lens. The illumination system lenses are made of glass with low UV absorption and configured to be telecentric in both object and image space. The DMD has a typical acceptance angle of 12° half angle. When activated, each of the individual mirror pixels on the DMD is tilted either +12 or -12 degrees to the plane of the DMD to direct the ultraviolet energy either toward the projection lens or toward an absorber. In this way, a controlled image can be digitally projected of a desired spatial contrast only limited by the spatial resolution of the DMD. Embodiments of the illuminator thereby comprise a source of UV energy with high uniformity within a specific area and angle space as required by the DMD and projection system to which it is interfaced. A low spatial non-uniformity on the DMD of less than 5% peak to peak is readily achieved.

The taper is designed with a far field distribution which overfills the stop of the UV illumination lens system to increase radiance by trading off efficiency and taking account of the fact that rays at smaller emitted angles from the LED surface have less power as emitted from a Lambertian source due to the decrease in projected area with increasing angle. Therefore, by increasing the size and thereby, the Etendue (area, solid angle, index squared product) of the LED array and purposely rejecting high angular extent rays relative to the surface normal as emitted by the LED array as they are absorbed by the optical stop of the lens system, the radiance on the DMD can be increased from what it would be limited to by a purely Etendue conserving design. Embodiments of the illuminator can, however, work with a smaller taper and LED array designed to conserve Etendue and achieve high spatial uniformity, but at a lower radiance.

In another preferred embodiment, the size of the output face of the taper is increased from that of the previously described taper. For the same input aperture size, this reduces the far field angular extent of the taper collection optic to match that of the illumination lens system defined by the stop of the system of lenses and selected to match the far field acceptance angle of 12° half angle required by the DMD. A highly reflective mirror is deposited on the output face of the taper with the same aperture size which is imaged onto the DMD. In alternative embodiments, the reflective mirror may be provided as a reflective surface pattern on an adjacent surface of a window disposed near or at the output face of the taper or as a reflective surface pattern on the front surface of a lens element disposed nearest to the taper. The masked-off (transmissive) portion of the mirrored output face allows UV energy to exit the non-mirrored output face at the appropriate size to fill the DMD. The UV energy that is incident on the internal mirrored surface of the taper is directed back towards the LED array where it has an opportunity to diffusely scatter off the LED array back toward and exit out of the aperture of the taper. In this way, the UV energy emitted by the LED array that would otherwise by absorbed by the stop is allowed to scatter back to the exit aperture of the taper within the acceptance angle of the optical system, thereby further increasing intensity on the DMD. The first embodiment described above with no mirror on the taper output face results in approximately 22% of the optical power incident on the lens stop being outside the dimension of the stop and thereby being blocked. Thus the mirrored taper embodiment can result in an improvement on the order of 15% or more in the total power incident on the DMD.

UV LED die with center wavelengths ranging between 360 nm and 405 nm are readily available and can be driven up to the order of 5 Amperes per square millimeter current density, assuming the high thermal efficiency design described above. In other embodiments according to the principles of the invention as described herein, the illuminator is a visible LED DMD illuminator or an infrared LED DMD illuminator.

In one aspect, the invention features a LED projector for a micromirror device. The LED projector includes at least one LED die and a non-imaging collection optic having an input aperture in optical communication with the at least one LED die and having an output aperture. The LED projector further includes a lens system in optical communication with the output aperture of the non-imaging collection optic and configured to generate an image of the output aperture in an image plane. The lens system is telecentric in an object space which includes the output aperture of the non-imaging collection optic. In some embodiments, the lens system is also telecentric in an image space which includes the image plane.

In another aspect, the invention features a digital micromirror illumination system that includes at least one LED die, a non-imaging collection optic, a lens system and a DMD. The non-imaging collection optic has an input aperture in optical communication with the at least one LED die and has an output aperture. The lens system is in optical communication with the output aperture of the non-imaging collection optic and is configured to provide an image of the output aperture in an image plane. The lens system is telecentric in an object space that includes the output aperture of the non-imaging collection optic. The DMD includes a plane of micromirrors disposed in the image plane.

### BRIEF DESCRIPTION OF THE DRAWINGS

The structure, operation, and methodology of the invention, together with other objects and advantages thereof, may best be understood by reading the following detailed description in connection with the drawings in which each part has an assigned numeral or label that identifies it wherever it appears in the various drawings and wherein:
Fig. 1 is a diagrammatic isometric view of a preferred embodiment of a high radiance UV LED illuminator comprising LED Board, heat exchanger, and lens assembly. The relative position and size of the illumination image are shown.
Fig. 2 is a diagrammatic isometric view of the system of Figure 1 indicating additional detail.
Fig. 3 is a diagrammatic cross sectional view of the system of Figure 1 showing internal optical and mechanical components as well as the LED array interfaced to the non-imaging collection optic.
Figs. 4A and 4B show, respectively, a diagrammatic isometric view and a cross sectional view of the LED board and collection optic of the system of Figure 1.
Figs. 5A and 5B show, respectively, a diagrammatic isometric view of the system of Figure 4 with the collection optic removed and a close up of the LED array and heat spreader.
Figs. 6A and 6B show, respectively, a top view and side view of the optical system of Figure 3 indictating the rays as transmitted out of the collection optic aperture and onto the DMD illuminaiton plane.
Figs. 7A, 7B and 7C show, respectively, a diagrammatic isometric view of an alternative embodiment of the collection optic of Figure 3 with reflective aperture, and top and side views showing how rays pass through the output aperture and reflect off the internal mirrored aperture of the collection optic and back through the exit aperture.

### DETAILED DESCRIPTION

The present invention relates to LED illumination used for the photopolymerization of materials with controlled spatial structure, i.e., imaged UV energy, afforded by imaging the output of a high power UV LED array onto the aperture of a DMD and subsequently through a projection lens and onto a desired surface of illumination.

Embodiments of the present invention include an LED based illumination source for improved intensity and spatial uniformity at the illumination plane which results in higher throughput which in turn decreases the cost of manufacturing processes relative to prior art. The present invention is distinguished from conventional illumination sources in that it comprises a high radiance profile with high spatial uniformity which optimizes system performance and results in much improved lifetime due to minimizing thermal impedance between the bottom side of the LED die and associated heat sinking elements.

A further advantage is the ability to use multiple UV spectral bands one at a time, or together in any spectral combination and relative intensity, to allow effective use of a wider variety of pliotoinitiators. For example, one preferred embodiment described herein uses two discrete cathode traces allowing for the use of two different UV die wavelengths. The absorption spectrum of various photoinitiators can vary as a function of exposure time, so the ability to combine more than one spectral band in a single system allows for a more complete cure for certain types of photocured materials. It should be obvious to those of skill in the art that the number of distinct spectral bands can be extended to any number up to the total number of LED die in the array if desired with appropriate features for wire bonding on the heat spreader and LED board, as well as related current drive sources.

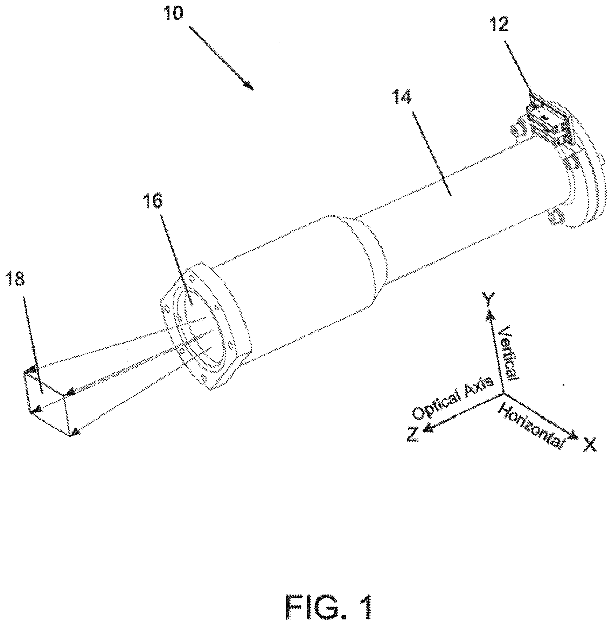

Referring now to Fig. 1, there is shown a diagrammatic, isometric view of the outside of a preferred embodiment of the UV LED DMD illumination source designated generally as system 10. The UV LED illumination source system 10 comprises an LED assembly 12, a lens housing 14, and a lens system of which the most distal lens element 16 is shown. The illumination device projects an image 18 along the Z-axis which is positioned coincident with a DMD device with similar aperture extents and comprising telecentric illumination at each position on the DMD within a 12° half angle of acceptance. The long axis of the rectangular DMD aperture is oriented along the horizontal X-axis and the short axis of the aperture in the vertical Y-axis. Typically the size of the illuminated image from the system 10 overfills the DMD slightly, for example by 5% to 10% to account for system positional tolerances.

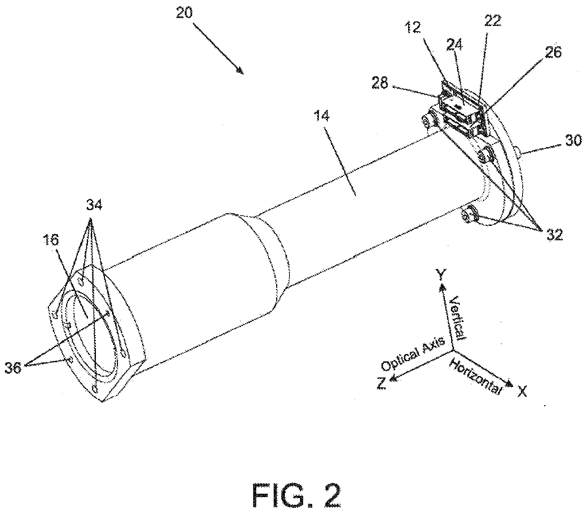

Referring now to Fig. 2, there is shown a diagrammatic isometric view 20 of the illumination source 10 of Fig. 1 showing additional structure of the illumination assembly. LED board assembly 12 is sandwiched between the flange of the lens housing 14 and the water heat exchanger assembly 30 by three bolts 32 positioned symmetrically about the flange at 120 degree intervals to apply uniform pressure of the back side of the LED board 22 and the water heat exchanger 30. A thin uniform layer of high thermal conductivity material such as silver conductive grease, aluminum oxide thermal grease, phase change thermal gap filling material, solder, diamond thermal paste, etc. is deposited between the back side of copper LED board 22 and heat exchanger face of heat exchanger 30 to optimally couple heat between the devices. In a preferred embodiment silver filled thermal grease is used. One eight-pin high current connector 24 is used for the common anode connection. An additional eight-pin connector 26 is used for the cathode; however, it is divided into four pins per 2 channels to allow for use of 2 different spectral bins of UV LED die. This can readily be extended up to the total number of LED die in the array, if desired. There is also a photosensor and thermistor attached to the LED board which is connected by a smaller, low current connector 28. The front flange, surrounding distal lens 16, has a pair of kinematic interface features 36 comprising a hole and a slot to assure that the illumination system can be accurately and repeatedly attached to the mating DMD assembly (not shown) by four bolts going through four holes 34 on the distal flange of the lens housing 14.

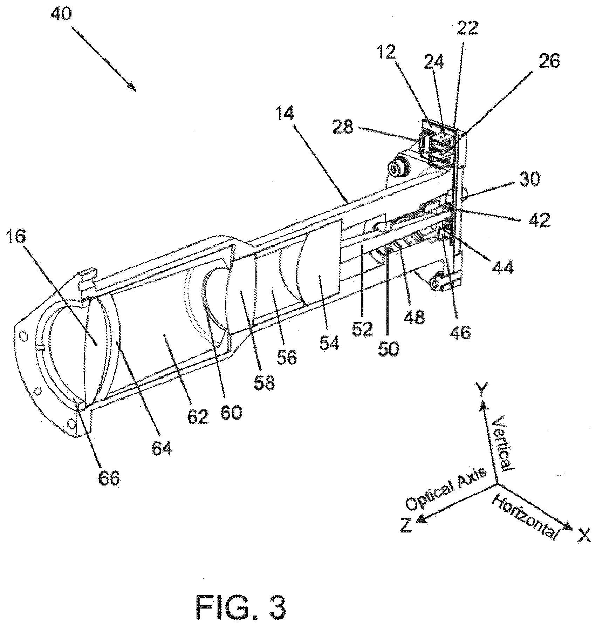

Referring now to Fig. 3, there is shown a diagrammatic cross section of an isometric view of the system 20 of Fig. 2. With reference from right to left, the water heat exchanger 30 can have microchannel features to allow water to flow with optimal exchange of heat between the copper material it is made of and the water flowing between the heat exchanger inlet and outlet at a given flow rate. The back of the LED board 12 comprising a sheet of copper 22 is thermal interfaced to the heat exchanger 30 with silver filled thermal paste. The LED die array 42 is shown interfacing proximally to a tapered straight sided non-imaging collection optic 52 within its rectangular aperture, the details of which will be made clear below. The collection optic 52, commonly referred to as a taper, is centered and held in position relative to LED array 42 by holders 44 and 50 with spring 48 pushing the taper up against first lens element 54. A spacer 56 positions second lens element 58 up against the lens systems aperture stop 60 which also functions as a spacer for third lens element 64. Lens element 64 makes direct contact near its outer edge with distal lens element 16, thereby requiring no spacer. A lens retainer 66 holds the four lens elements and two spacers securely up against the seat in the housing 14 of lens 54. This resists the spring 48 from pushing the lens 54 toward the output of the lens systems and assures that the taper 52 is reliably positioned in distance by the order of 100 to 200 microns from the LED array 42. A shim is used between LED board assembly 12 and the proximal flange of lens housing 14 to set the distance between the LED array 42 and input to the taper collection optic 52 to account for manufacturing tolerances.

The glass elements 52, 54, 58, 64, and 16 in a preferred embodiment are made out of a low UV absorption glass type such as fused silica, but can be made of other low dispersion UV transparent glass materials such as BK7 or B270, crystalline materials, salts, diamond, sapphire or UV transparent silicone or sol gels. Optimally, the materials are anti-reflection coated to minimize Fresnel reflective losses and to minimize ghosting at the illumination plane. The housing 14 is made of black anodized aluminum in a preferred embodiment due to its low mass, high thermal conductivity and reasonably low thermal expansion coefficient and low cost. High flux UV energy can degrade standard black anodization so more robust coatings, such as Optic Black™ manufactured by Pioneer Metal Finishing of Green Bay, Wisconsin, are preferably used. Standard anodization will turn color and result in deposits onto the lens elements which can result in loss of optical power. Additionally, the difference in thermal expansion coefficients between the optic materials and the housing and spacers are selected to minimize temperature dependent changes in focus.

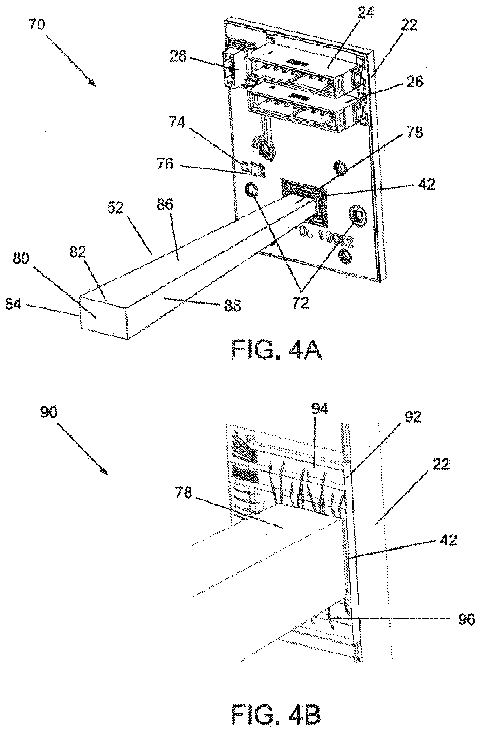

Referring now to Fig. 4A, there is shown a diagrammatic isometric view 70 of the LED board assembly 12 of Fig. 3 as interfaced to collection optic 52. Fig. 4A affords a better view of anode connector 24 and cathode connector 26 as well as photosensor and thermistor connector 28. The thermistor 74 and photosensor 76 are shown to the upper left of the LED array 42. The thermistor allows a control system to continually monitor temperature in the event that the cooling system is turned off or fails. Such a control system quickly shuts off the LED die array in the event of a sudden spike in temperature to avoid catastrophic failure. An additional use of the thermistor is to enable a temperature sensitive correction of the output by calibrating output of the LED array as a function of current and temperature. For example, if the ambient temperature were to increase then the temperature dependent output of the LED array would decrease. A closed loop system can be controlled by an analog or digital control loop to adjust the output current to maintain constant LED output power.

This approach of monitoring output with a thermistor, however, does not account for long term decreases in LED output with time. Therefore, a photosensor 76, which is comprised of a UV sensitive detector, such as a silicon photodiode coupled to a transimpedance amplifier, is able to monitor changes in output and drive the current higher through a closed loop control to maintain constant output power over both time and temperature. The bottom cavity of the housing 14 has features that allow a small amount of the UV energy emitted by the LED array to be sampled. Alternatively, a separate photosensor off the LED board can be used to look transverse to the Z-axis in the middle of the collection optic 52 to sample the amount of UV energy transmitted by the system. Silicon photosensors are very stable with time and the applicable temperature range and thus make an accurate measurement of optical power.

The taper 52 is comprised of a rectangular input side 78 mating within less than 500 microns of the LED array 42 and with an aspect ratio similar to that of the DMD, although strictly speaking the aspect ratio of the output aperture 80 comprising long side 82 and small side 84 is what is imaged onto and determines the size of the DMD illumination. If the aspect ratio in the two orthogonal directions of the input and output apertures are not the same then the far field is not symmetric, but assuming the aperture stop of the illumination system is circular, the resulting far field is circular so it is not a requirement that the aspect ratios of input and output of the taper be the same. Thus, the aspect ratio of output face 80 of tapered collection optic 52 is preferably substantially similar to that of the DMD micromirror array positioned at illumination plane 18 of Fig. 1. The sides of the taper are substantially flat with larger face 86 and smaller face 88 symmetric on two opposite sides. The purpose of the taper is to capture the UV energy emitted by LED array 42 which extends over a hemisphere in angle space (2π steradians) and convert it into a smaller angle θ with respect to the optical Z-axis that is equal to or greater than the 12° half angle required at the input of the lens system of Fig. 3 to assure that the lens system aperture stop 60 of Fig. 3 is fully filled, otherwise the output would be reduced. As will be described in greater detail below, the output of the taper in a preferred embodiment overfills the aperture stop 60 by an amount that blocks approximately 22% of the power incident on it. Additionally, since the DMD micromirrors are dithered along one plane, it is possible to limit the angular acceptance of rays in the mirror plane to the required 12° half angle, but increase the angle in the orthogonal axis to effectively increase the average numerical aperture of the system and thereby further increase intensity on the illumination plane. This approach requires the projection lens system to have an equivalently shaped elliptical (or rectangular) aperture stop to pass all the power exiting the DMD.

Also indicated in Fig. 4A are a pair of opposed holes 72 through the LED board copper substrate 22 which are interfaced to two kinematic pins, one round, one oval to allow the position of the taper input aperture 78 to be accurately and reliably positioned relative to the LED array 42. These two holes 72 act as the datum feature to which the LED die array is aligned.

With reference now to Fig. 4B, a diagrammatic cross sectional view 90 of a close up of the area near the LED array of Fig. 4A is shown. A synthetic polycrystalline diamond heat spreader 92 is attached to LED board copper substrate 22 by use a high thermal conductivity solder. The LED die array 42 is attached to gold plated traces on the top of the diamond heat spreader by use of a similar high thermal conductivity substantially void free solder. The LED die can be operated at a current up to the order of 5 Amperes per square centimeter at a voltage on the order of 5 Volts. That results in a heat flux on the order of 2,000 W/cm2. The transverse thermal conductivity of diamond heat spreaders is on the order of 2000 W/m-K, which is roughly five times that of bulk copper. Diamond heat spreaders are anisotropic so the thermal conductivity in the thin dimension (into the heat spreader Z-Axis) is less but still on the order of 600 W/m-K, which is still better than bulk copper. Thus, the heat spreader acts to spread the heat out in the X-Y plane and thereby reduces the heat flux into the copper substrate 22, which further spreads the heat before entering the water heat exchanger 30, of Fig. 4A. The diamond heat spreader 22 has gold traces 94 to which wire bonds 96 are attached from the top of the LED die and in turn those traces are attached by a series of wire bonds to the copper traces on top of the COB.

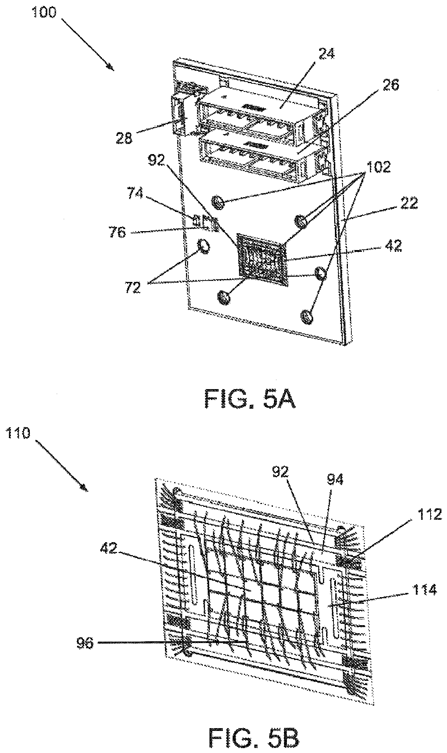

Reference is now made to Fig. 5A which shows a diagrammatic isometric view of the system of Fig. 4A with the tapered collection optic 52 removed. The additional features on the board shown in this view comprise four symmetrically opposed holes 102 which allow the LED board to be attached to the housing 14 prior to attachment of the water heat exchanger 30 of Fig. 2. Fig. 5B shows a diagrammatic isometric close up view of the LED die array 42 and heat spreader 92. There are three rows of six each UV LED die closely packed together to form an eighteen die array for use with a 1080p 0.95 in. diagonal Texas Instruments® DMD device. Another embodiment of the system uses the same lens system, housing and LED board but is designed for the 1024 by 768 by 0.70 in. diagonal Texas Instruments® DMD device and is comprised of a proportionally smaller taper and a three by four die array of UV LEDs. The typical LED die is approximately 1,000 microns square by about 100 microns in thickness with two each wire bond pads per die. There arc two sets of wire bond traces on top and bottom of the central trace where the LED die are attached on the diamond substrate 92. The two sets allow for two different LED wavelength bins to be used to provide a broader spectrum. This is useful for some types of photoinitiators that may change their absorption spectrum throughout the photopolymerization process. Some photopolymers are known to have surface cure inhibition by oxygen preventing good surface curing. The use of UV energy on the order of 250 nm to 280 nm has been shown to prevent this. Such a system can be accommodated with the approach detailed above making use of the recently released 280 nm LED die that are now commercially available. It will be obvious to those of skill in the art that the number of different spectral bins can be extended up to the number of individual LED die if desired with appropriate features on the diamond heat spreader and LED board.

The diamond heat spreader 92 of Fig. 5B is expensive so it is important for overall cost and performance to determine how large the heat spreader should be. As the size of the heat spreader increases, it has less incremental benefit. The relative size of the LED array shown in the preferred embodiment of Fig. 5B is the order of 3.3 mm by 6.6 mm and the size of the diamond heat spreader is 8.0 mm by 10.0 mm which was found to be an optimal tradeoff between heat spreader size, reduction in ΔT between the back side of the LED board and the LED junction temperature and cost, resulting in a temperature drop on the order of 20°C to 25°C relative to room temperature of 25°C. This significant drop in temperature allows the LED die to be continuously operated at current densities on the order of 5 Amperes per centimeter squared and since they are at a lower temperature for a given intensity, they last longer. The lifetime of LED die is known to decrease exponentially with increasing junction temperature due to temperature dependent diffusion processes within the diode junction. Computational Fluid Dynamics (CFD) software packages such as SolidWorks® Flow® can be used to run simulations to determine optimal heat spreader size. Alternatively, the data can be determined empirically.

The LED die array shown in Fig. 5B is attached on the bottom side in a common anode configuration to allow the die to be butted together thereby maximizing the radiance. One down side of common anode is that if all the cathodes are tied together to the same current source then differences in forward voltage between LED die can lead to differences in current through each die. This in turn leads to differences in temperature dependent aging. Common anode prevents the LED die from being wired in series to assure that each die gets the same current. In another embodiment of the invention, each LED die is wire bonded to an independent current source. In this way, it is possible to get the thermal and tight packing advantages as well as precise control of each LED die. Additionally, such a current driving scheme is better than series connection since the failure of one LED die does not affect the other die as in a series connection. A further advantage of driving each LED die is that the forward voltage of each can be monitored with time and the system can go through a calibration at start up to monitor the output of each LED die with time to predict lifetime and inform the operator of any future maintenance that may be required.

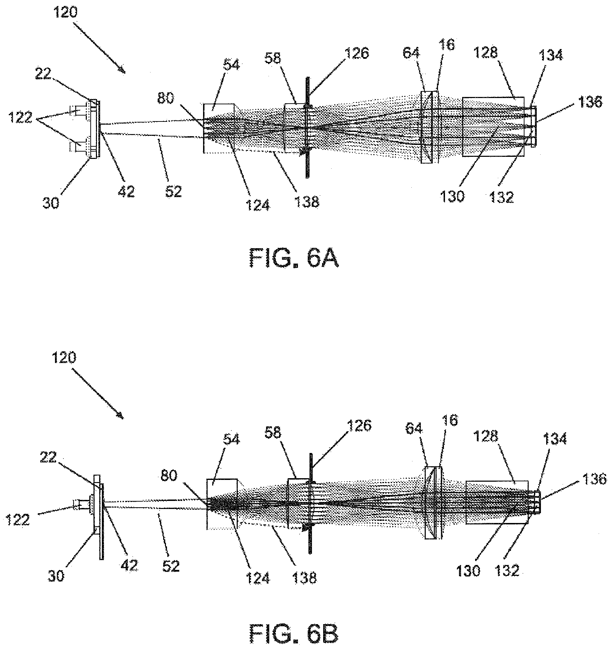

With reference now to Fig. 6A, a diagrammatic top view 120 of the system of Fig. 1 is shown with the housing, spacers, and taper holder components removed for clarity. Lines 124 emanating from the output aperture 80 of tapered collection optic 52 and lines 130 converging from lens 16, respectively, are shown to indicate the optical ray paths as imaged between the taper output aperture and the DMD micromirror surface 136. Rays exiting from a given point on the output of the taper surface 80 converge toward a point of rays 134 on the DMD with the chief ray normal to the DMD surface in a telecentric condition as required for proper use of the DMD. A block of glass 128 is shown positioned between the last lens element 16 of the illumination system and the glass cover plate 132 of the DMD to represent the optical effect (unfolded path) of a total internally reflecting (TIR) coupling prism. This type of prism is often used to couple the illumination into the DMD at an angle of incidence on the order of 24°. For systems that do not incorporate a TIR prism and therefore have a greater angle of incidence on the DMD, there can be a more significant keystone effect due to entering and or exiting the DMD at a larger angle relative to the normal to its surface. Such a TIR prism is used in a preferred embodiment of a 0.95 in. diagonal UV illuminator shown here, however, it will be recognized by those of skill in the art, that the invention could be used without a TIR prism. The optical design is optimized with a piece of glass representing the prism to take proper account of and correct for the aberrations, however, the prism is not included as part of the illumination housing. Rays emitted from aperture 80 but outside the angle space of the lens systems aperture stop 126 arc absorbed by the stop and are prevented from transmitting toward the DMD 136. The system of lenses 54, 58, 64, and 16 are designed to be telecentric in both object (taper output aperture) and image (DMD micromirror plane) space. On the object side, telecentricity approximates the virtual far field of the taper, which is also a function of taper length.

In the case where no TIR prism is used to couple the UV energy to the DMD, it is possible to correct for increased keystone by adding a rectangular cross section hollow end piece as an extension to the taper. This hollow end piece directly butts the taper on the proximal side and has a tilted plane in the opposite direction of the tilt of the DMD relative to the optical Z-Axis of the illumination system of Fig. 1. This method of imaging a tilted plane can be used to compensate and substantially correct for increased keystone resulting from direct imaging onto the DMD without a TIR prism. It is critical that the short hollow internally reflective walled device be used at the end of the taper instead of just tilting the output face of the taper, since doing so results in refraction and therefore steering of the chief rays.

The taper 52 of Fig. 6A is designed with a far field distribution which overfills the aperture stop 126 of the UV illumination lens system to increase radiance. This is accomplished by trading off efficiency by recognizing that rays at smaller emitted angles from the LED surface have less power as emitted from a Lambertian source due to the decrease in projected area with increasing angle, which is the well know cosine θ effect. Therefore, by increasing the size and thereby, the Etendue of the LED array 42 and purposely rejecting high angular extent rays emitted by the LED array 42 as they are absorbed by the optical stop 126 of the lens system, the radiance on the DMD 136 can be increased from what it would be limited to by a purely Etendue conserving design. This system can, however, work with a smaller taper and LED array designed to conserve Etendue and achieve high spatial uniformity, but at a lower radiance since the fewer LED die that are required for Etendue conserving designs are proportionally smaller and therefore operate at higher current density and lower efficiency relative to driving a larger array. This concept of trading off efficiency for increased radiance is highly beneficial. The water heat exchanger 30 has input and output ports (reversible) 122 that are attachable to a water to air heat exchanger by use of tubing clamped to hose barbs on 122.

Fig. 6B shows a diagrammatic side view 120 of the system of Fig. 6A representing the narrow output dimension of the taper 52 and DMD 136. Likewise collectively rays 138 that are emitted at angles larger than the aperture stop 126 are absorbed by it and prevented from transmitting to the DMD. It should be noted that in both Fig. 6A and 6B, only those rays that pass through the aperture stop 126 are shown. Rays at higher angles that are emitted by the taper 52 and overfill the aperture stop 126 are not shown.

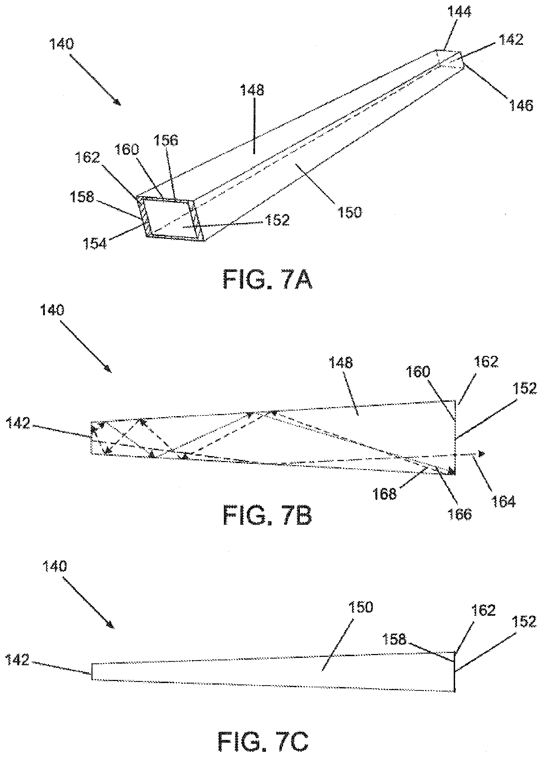

With reference now to Fig. 7A, an alternative embodiment 140 of a tapered collection optic is show in diagrammatic isometric view. The input aperture 142 has long side 144 and short side 146 with a substantially rectangular aperture. Short side 150 and long side 148 are shown corresponding to short output edge 158 and long output edge 160, respectively. As was the case for the taper described above, all six sides of the taper are polished to reduce or minimize surface scattering and are generally made of glass such as fused silica, UV grade low fluorescence Schott BK7 or B270 glass or equivalent. UV rays reflect multiple times as they progress down the taper by total internal reflection. This is a much more efficient reflection means in comparison to reflective hollow tapers, which suffer significant cumulative reflective losses, particularly in the UV where it is more difficult to achieve a high reflectivity coating. The input aperture dimensions of the taper 140 are identical to that of taper 52 as they are both designed to interface to the same LED array 42; however, the output dimensions are proportionally larger. The output dimensions for taper 140 are chosen such that the angular extent of the taper output matches that required to fill the aperture stop of the system of Figs. 1, 2, 3, and 6. This contrasts to the taper 52 which was specifically designed to overfill the lens aperture stop and take advantage of the cosine θ effect as described above for trading off efficiency for intensity. By changing to the configuration of taper system 140 with a matched far field and by recovering the UV energy that reflects back down the taper off of a high reflectance mirror coating 162, the UV energy that is otherwise absorbed by the aperture stop 126 is partially recovered.

Fig. 7B shows a diagrammatic top view of the taper 140 of Fig. 7A. Ray 166 emitted by the LED array and passing through input aperture 142 reflects off the sides of the taper 140 by total internal reflection and impinges on internally mirrored surface 162 as indicated by ray 168. When ray 168 strikes the LED array, it is diffusely scattered back toward the taper with most of the energy passing back out of aperture 152 and is thereby recovered and can result in an increase by 15% or more in the intensity at the illumination plane. Most of the rays 164 like those recovered rays just described pass directly out of the aperture 152. It will be clear to those of skill in the art that further increases in intensity can be achieved by increasing the LED array size, input and output apertures of the taper, but maintaining the same exit aperture size 152. There are diminishing returns, however, as the increased heat load from the array can reduce the output per LED thereby decreasing the benefit. In addition, the larger the area of the mirrored surface 162 relative to the exit aperture 152, the lower the efficiency due to finite reflective losses of the mirror and LED surfaces as well as losses out the gap between the input aperture 142 of the taper and the LED array 42.

Fig. 7C shows a diagrammatic side view of the narrow dimension of taper 140 of Fig. 7A. The same effect is true for this view for rays striking the mirror surface 162 and returning down the length of the taper, reflecting off the LED array and exiting out of aperture 152. Some of the light that is reflected back off the LED array will be incident on the mirror 162 again. The more times this happens, the more loss occurs for such rays, which again is why there are diminishing returns as the mirrored area size approaches that of the emitting aperture area.

Other shapes that can be used for the non-imaging collection optic include compound parabolic concentrators (CPCs). The system is characterized by the requirement to have high near field uniformity at the output of the collection optic. Non-imaging straight walled collection optics with an even number of sides are excellent at producing very high near field uniformity at their output. CPCs work well as concentrators (or collectors in reverse), however; a CPC only results in uniform near field output at its exit aperture if the input aperture is uniformly filled. That precludes the use of more than one spectral bin of LED die as can be accommodated by embodiments described above. Furthermore, unless a mold process is used, glass CPCs are more difficult to make than tapers which can be conventionally polished. It is possible to substitute a rectangular four sided CPC in this system for the taper assuming only a single wavelength bin was used, however, even with a single wavelength bin LED die array, the uniformity achieved with a taper is generally better than that achieved with a CPC of an equivalent length.

### Aspects of the invention

1. A light emitting diode (LED) projector for a micromirror device comprising:
   at least one LED die;
   a non-imaging collection optic having an input aperture in optical communication with the at least one LED die and having an output aperture; and
   a lens system in optical communication with the output aperture of the non-imaging collection optic and configured to generate an image of the output aperture in an image plane, the lens system being telecentric in an object space which includes the output aperture of the non-imaging collection optic.
2. The LED projector of aspect 1 wherein the lens system is telecentric in an image space which includes the image plane.
3. The LED projector of aspect 1 wherein the input aperture and output aperture are rectangular apertures.
4. The LED projector of aspect 1 wherein the output aperture is defined by the dimensions of an output face of the non-imaging collection optic.
5. The LED projector of aspect 3 wherein the output aperture is defined by a rectangular transmissive region inside a reflective mirror deposited on an output face of the non-imaging collection optic.
6. The LED projector of aspect 3 wherein the output aperture is defined by a rectangular transmissive region inside a reflective mirror deposited on a window disposed adjacent to the output face of the non-imaging collection optic.
7. The LED projector of aspect 3 wherein the output aperture is defined by a rectangular transmissive region inside a reflective mirror deposited on a front surface of a lens element in direct optical communication with the output face of the non-imaging collection optic.
8. The LED projector of aspect3 wherein the rectangular apertures have an aspect ratio that substantially matches an aspect ratio of a digital micromirror device.
9. The LED projector of aspect 1 wherein the non-imaging collection optic is a tapered glass light pipe.
10. The LED projector of aspect 1 wherein the non-imaging collection optic is a compound parabolic concentrator.
11. The LED projector of aspect 1 wherein the non-imaging collection optic is configured to provide a far field distribution that overfills an aperture stop of the lens system.
12. The LED projector of aspect 1 wherein the non-imaging collection optic is configured to provide a far field distribution that is substantially matched to an aperture stop of the lens system.
13. The LED projector of aspect 1 wherein the at least one LED die comprises an array of ultraviolet emitting LEDs.
14. A digital micromirror illumination system comprising:
   at least one light emitting diode (LED) die;
   a non-imaging collection optic having an input aperture in optical communication with the at least one LED die and having an output aperture;
   a lens system in optical communication with the output aperture of the non-imaging collection optic and configured to provide an image of the output aperture in an image plane, the lens system being telecentric in an object space that includes the output aperture of the non-imaging collection optic; and
   a digital micromirror device (DMD) comprising a plane of micromirrors disposed in the image plane.
15. The digital micromirror illumination system of aspect 14 wherein the lens system is telecentric in an image space that includes the image of the output aperture.
16. The digital micromirror illumination system of aspect 14 further comprising a total internally reflecting coupling prism disposed between the lens system and the DMD.
17. The digital micromirror illumination system of aspect 14 further comprising a taper extension abutting the non-imaging collection optic at the output aperture and having a plurality of internally reflective walls defining a hollow rectangular cross section tilted at an angle determined to compensate and substantially correct for a non-uniformity due to keystone effect.
18. The digital micromirror illumination system of aspect 14 wherein the input aperture and output aperture are rectangular apertures.
19. The digital micromirror illumination system of claim of aspect 14 wherein the output aperture is defined by the dimensions of an output face of the non-imaging collection optic.
20. The digital micromirror illumination system of aspect 18 wherein the output aperture is defined by a rectangular transmissive region inside a reflective mirror deposited on an output face of the non-imaging collection optic.
21. The digital micromirror illumination system of aspect 18 wherein the rectangular apertures have an aspect ratio that substantially matches an aspect ratio of the DMD.
22. The digital micromirror illumination system of aspect 14 wherein the at least one LED die comprises an array of ultraviolet emitting LEDs.
23. A light emitting diode (LED) projector for a micromirror device comprising:
   at least one LED die;
   a non-imaging collection optic having an input aperture in optical communication with the at least one LED die and having an output aperture; and
   a lens system in optical communication with the output aperture of the non-imaging collection optic and configured to generate an image of the output aperture in an image plane, the lens system being telecentric in an object space which includes the output aperture of the non-imaging collection optic and being telecentric in an image space which includes the image plane.
24. The LED projector of aspect23 wherein the input aperture and output aperture are rectangular apertures.
25. The LED projector of aspect 24 wherein the output aperture is defined by a rectangular transmissive region inside a reflective mirror deposited on an output face of the non-imaging collection optic.
26. The LED projector of aspect24 wherein the output aperture is defined by a rectangular transmissive region inside a reflective mirror deposited on a window disposed adjacent to the output face of the non-imaging collection optic.
27. The LED projector of aspect 24 wherein the output aperture is defined by a rectangular transmissive region inside a reflective mirror deposited on a front surface of a lens element in direct optical communication with the output face of the non-imaging collection optic.

## Claims

1. A light emitting diode (LED) projector for a digital micromirror device (DMD) comprising:
at least one LED die;
a DMD;
a non-imaging collection optic having an input aperture in optical communication with the at least one LED die and having an output aperture;
an illumination lens system in optical communication with the output aperture of the non-imaging collection optic and the DMD, and configured to generate an image of the output aperture in an image plane that includes the DMD, the illumination lens system being telecentric in an object space which includes the output aperture of the non-imaging collection optic, the illumination lens system having a first aperture stop having an elliptical or rectangular shape to limit the angular acceptance of light in a mirror plane of the DMD relative to an angular acceptance of light in an orthogonal plane to thereby increase the average numerical aperture of the illumination lens system; and
a projection lens system in optical communication with the DMD and having a second aperture stop having an elliptical or rectangular shape to pass all the power exiting the DMD.

2. The LED projector of claim 1 wherein the illumination lens system is telecentric in an image space which includes the image plane.

3. The LED projector of claim 1 wherein the input aperture and output aperture are rectangular apertures.

4. The LED projector of claim 1 wherein the output aperture is defined by the dimensions of an output face of the non-imaging collection optic.

5. The LED projector of claim 3 wherein the output aperture is defined by a rectangular transmissive region inside a reflective mirror deposited on an output face of the non-imaging collection optic.

6. The LED projector of claim 3 wherein the output aperture is defined by a rectangular transmissive region inside a reflective mirror deposited on a window disposed adjacent to the output face of the non-imaging collection optic.

7. The LED projector of claim 3 wherein the output aperture is defined by a rectangular transmissive region inside a reflective mirror deposited on a front surface of a lens element in direct optical communication with the output face of the non-imaging collection optic.

8. The LED projector of claim 3 wherein the rectangular apertures have an aspect ratio that substantially matches an aspect ratio of the DMD.

9. The LED projector of claim 1 wherein the non-imaging collection optic is a tapered glass light pipe.

10. The LED projector of claim 1 wherein the non-imaging collection optic is a compound parabolic concentrator.

11. The LED projector of claim 1 wherein the non-imaging collection optic is configured to provide a far field distribution that overfills the first aperture stop.

12. The LED projector of claim 1 wherein the non-imaging collection optic is configured to provide a far field distribution that is substantially matched to the first aperture stop.

13. The LED projector of claim 1 wherein the at least one LED die comprises an array of ultraviolet emitting LEDs.

14. The LED projector of claim 1 further comprising a total internally reflecting coupling prism disposed between the illumination lens system and the DMD.

15. The digital micromirror illumination system of claim 1 further comprising a taper extension abutting the non-imaging collection optic at the output aperture and having a plurality of internally reflective walls defining a hollow rectangular cross section tilted at an angle determined to compensate and substantially correct for a non-uniformity due to keystone effect.
